# EUROPEAN PATENT APPLICATION

(11) **EP 4 692 429 A1**
(43) Date of publication of application: **11.02.2026**
(21) Application number: 23932000.5
(22) Date of filing: 05.04.2023
(51) Int. Cl.: C30B 29/16, C30B 11/00

(54) **DIGALLIUM TRIOXIDE SINGLE CRYSTAL SUBSTRATE, METHOD FOR PRODUCING DIGALLIUM TRIOXIDE SINGLE CRYSTAL, AND METHOD FOR PRODUCING DIGALLIUM TRIOXIDE SINGLE CRYSTAL SUBSTRATE**

(71) Applicant: Sumitomo Electric Industries, Ltd., Osaka-shi, Osaka 541-0041 (JP)
(72) Inventor: ISHIKAWA, Yukio, Osaka-shi, Osaka 541-0041 (JP); TANIZAKI, Keisuke, Osaka-shi, Osaka 541-0041 (JP)
(74) Representative: Grünecker Patent- und Rechtsanwälte PartG mbB
(86) International application number: PCT/JP2023/014084
(87) International publication number: WO 2024/209588

(57) **Abstract**

In the present invention, a digallium trioxide single crystal substrate has a circular main surface, the diameter of the digallium trioxide single crystal substrate being at least 100 mm, the main surface being the (100) plane of the digallium trioxide single crystals constituting the digallium trioxide single crystal substrate, the main surface having a central portion containing the center of the main surface and an outer peripheral portion surrounding the outer periphery of the central portion, and the outer peripheral portion being a processed part that has been chamfered. First nanoindention hardnesses measured according to a nanoindention method using a Berkovich indenter at nine locations on the main surface are all 13-20 GPa under a first condition in which the maximum load is set at 10 mN and a load is applied such that the angle of intersection of one side of the indention and the direction in which the [100] direction of the digallium trioxide single crystal projects onto the main surface is 0-10°.

## Description

### TECHNICAL FIELD

The present disclosure relates to a digallium trioxide single-crystal substrate, a method of manufacturing a digallium trioxide single-crystal, and a method of manufacturing a digallium trioxide single-crystal substrate.

### BACKGROUND ART

As disclosed in Japanese Unexamined Patent Application Publication No. 2008-303119 (Patent literature 1), the following Non-patent literature 1, and the like, it is known that a digallium trioxide single-crystal (hereinafter, also referred to as "Ga₂O₃ single crystal") constituting a digallium trioxide single-crystal substrate (hereinafter, also referred to as "Ga₂O₃ single-crystal substrate") has strong cleavability in a specific direction.

### CITATION LIST

### PATENT LITERATURE

Patent literature 1: Japanese Unexamined Patent Application Publication No. 2008-303119

### NON PATENT LITERATURE

Non-patent literature 1: Shimamura et al., "Powder and Powder Metallurgy", Vol. 52, No. 12 (2005), p. 918 to 922

### SUMMARY OF INVENTION

A digallium trioxide single-crystal substrate according to the present disclosure is a digallium trioxide single-crystal substrate including a circular main surface. The digallium trioxide single-crystal substrate has a diameter of 100 mm or more. The main surface is a (001) plane of a digallium trioxide single crystal constituting the digallium trioxide single-crystal substrate. The main surface has a central portion including a center of the main surface and an outer peripheral portion surrounding an outer periphery of the central portion. The outer peripheral portion is a chamfered region. First nanoindentation hardnesses measured at nine positions on the main surface in accordance with a nanoindentation method using a Berkovich indenter are each 13 GPa to 20 GPa under a first condition in which a maximum load is set to 10 mN and a load is applied such that a crossing angle between one side of an indentation and a direction in which a [100] direction of the digallium trioxide single crystal is projected on the main surface is 0° to 10°. When a length from the center of the main surface to a boundary between the central portion and the outer peripheral portion is r, two axes passing through the center and orthogonal to each other on the main surface are an X-axis and a Y-axis, and the Y-axis is a b-axis of the digallium trioxide single crystal, coordinates (X, Y) of the X-axis and the Y-axis at the nine positions are (0, 0), (r-5, 0), (0, r-5), (-(r-5), 0), (0, -(r-5)), (r-1, 0), (0, r-1), (-(r-1), 0), and (0, -(r-1)). Units of r and X and Y in the coordinates (X, Y) are mm.

### BRIEF DESCRIPTION OF THE DRAWINGS

[FIG. 1] FIG. 1 is an explanatory diagram illustrating a main surface of a Ga₂O₃ single-crystal substrate according to the embodiment.
[FIG. 2] FIG. 2 is an explanatory diagram illustrating measurement points at nine positions set on the main surface of the Ga₂O₃ single-crystal substrate of FIG. 1 in order to obtain first and second nanoindentation hardnesses.
[FIG. 3] FIG. 3 is a flowchart showing an example of a method of manufacturing a Ga₂O₃ single-crystal substrate including a method of manufacturing a Ga₂O₃ single crystal according to the embodiment.
[FIG. 4] FIG. 4 is a diagram schematically illustrating a manufacturing apparatus used in the method of manufacturing a Ga₂O₃ single crystal according to the embodiment.
[FIG. 5] FIG. 5 is an explanatory diagram illustrating one embodiment (first crucible) of a crucible included in the manufacturing apparatus used in the method of manufacturing a Ga₂O₃ single crystal according to the embodiment.
[FIG. 6] FIG. 6 is an explanatory diagram illustrating another embodiment (second crucible) of the crucible included in the manufacturing apparatus used in the method of manufacturing a Ga₂O₃ single crystal according to the embodiment.
[FIG. 7] FIG. 7 is an explanatory diagram illustrating, as a plan view, one embodiment of a plate-shaped member included in the manufacturing apparatus used in the method of manufacturing a Ga₂O₃ single crystal according to the embodiment.

### DETAILED DESCRIPTION

### [Problems to be Solved by Present Disclosure]

It has been pointed out that a Ga₂O₃ single-crystal substrate is easily cracked due to the strong cleavability of the Ga₂O₃ single crystal. However, a Ga₂O₃ single-crystal substrate with improved cracking resistance has not been obtained yet, and development thereof is desired.

In view of the above, an object of the present disclosure is to provide a digallium trioxide single-crystal substrate that is less likely to crack, a method of manufacturing a digallium trioxide single crystal, and a method of manufacturing a digallium trioxide single-crystal substrate.

### [Advantageous Effect of the Present Disclosure]

The present disclosure can provide a digallium trioxide single-crystal substrate that is less likely to crack, a method of manufacturing a digallium trioxide single-crystal, and a method of manufacturing a digallium trioxide single-crystal substrate.

### [Overview of Embodiment]

The following is a summary of embodiments of the present disclosure. The present inventors have made intensive studies to solve the above problems and completed the present disclosure. First, the present inventors focused on imparting a property of being less likely to form a starting point of fracture on the main surface by making the hardness of the Ga₂O₃ single crystal constituting the Ga₂O₃ single-crystal substrate uniform without variation in the crystal. In particular, the inventors have conceived of obtaining a Ga₂O₃ single crystal having a uniform crystal defect concentration without deviation by stabilizing the crystal growth rate. Thus, a Ga₂O₃ single-crystal substrate having a main surface with a predetermined hardness in-plane and uniform without variation was obtained from the Ga₂O₃ single crystal. In the Ga₂O₃ single-crystal substrate, starting points of fracture such as cracks are less likely to be formed in the main surface on the basis of the characteristics relating to the hardness described above. Thus, a Ga₂O₃ single-crystal substrate which is less likely to crack was achieved, and the present disclosure was completed.

Next, embodiments of the present disclosure will be listed and described.
[1] A digallium trioxide single-crystal substrate according to an aspect of the present disclosure is a digallium trioxide single-crystal substrate including a circular main surface. The digallium trioxide single-crystal substrate has a diameter of 100 mm or more. The main surface is a (001) plane of a digallium trioxide single crystal constituting the digallium trioxide single-crystal substrate. The main surface has a central portion including a center of the main surface and an outer peripheral portion surrounding an outer periphery of the central portion. The outer peripheral portion is a chamfered region. First nanoindentation hardnesses measured at nine positions on the main surface in accordance with a nanoindentation method using a Berkovich indenter are each 13 GPa to 20 GPa under a first condition in which a maximum load is set to 10 mN and a load is applied such that a crossing angle between one side of an indentation and a direction in which a [100] direction of the digallium trioxide single crystal is projected on the main surface is 0° to 10°. When a length from the center of the main surface to a boundary between the central portion and the outer peripheral portion is r, two axes passing through the center and orthogonal to each other on the main surface are an X-axis and a Y-axis, and the Y-axis is a b-axis of the digallium trioxide single crystal, coordinates (X, Y) of the X-axis and the Y-axis at the nine positions are (0, 0), (r-5, 0), (0, r-5), (-(r-5), 0), (0, -(r-5)), (r-1, 0), (0, r-1), (-(r-1), 0), and (0, -(r-1)). Units of r and X and Y in the coordinates (X, Y) are mm. The digallium trioxide single-crystal substrate having such characteristics may have a property of being less likely to be cracked.
[2] Second nanoindentation hardnesses measured at the nine positions in accordance with the nanoindentation method are preferably each 15 GPa to 20 GPa under a second condition in which the maximum load is set to 1 mN and the load is applied such that the crossing angle between the one side of the indentation and the direction in which the [100] direction of the digallium trioxide single crystal is projected on the main surface is 0° to 10°. This makes it possible to provide a digallium trioxide single-crystal substrate that is less likely to crack.
[3] A dislocation density of the central portion is preferably 100 cm⁻² or less. Thus, a digallium trioxide single-crystal substrate having a low density of defects in a single crystal and thus having high quality can be provided.
[4] The digallium trioxide single-crystal substrate preferably includes a dopant. The dopant is preferably tin or silicon. An atomic concentration of the dopant is preferably 2 × 10¹⁹ cm⁻³ or less. Thus, the digallium trioxide single-crystal substrate including the dopant may have a property of being less likely to be cracked.
[5] A method of manufacturing a digallium trioxide single-crystal according to an aspect of the present disclosure includes the following steps. That is, the method of manufacturing includes preparing a single crystal growth apparatus including at least a crucible having a cylindrical shape and a heating device disposed so as to surround an outer periphery of the crucible, placing a seed crystal in a bottom portion of the crucible, and placing a digallium trioxide bulk body that is in a form of a lump, a plate-shaped member composed of pyrolytic boron nitride, and boron oxide in a solid state in that order above the seed crystal in the crucible, by heating the crucible by the heating device to melt the digallium trioxide bulk body and a portion of the seed crystal, obtaining a digallium trioxide melt and bringing the digallium trioxide melt into contact with a remaining portion of the seed crystal, and obtaining the digallium trioxide single crystal by growing a crystal from the digallium trioxide melt on the remaining portion of the seed crystal. The bringing the digallium trioxide melt into contact with the remaining portion of the seed crystal includes disposing the plate-shaped member on the digallium trioxide melt and turning the boron oxide into liquid. An atmosphere in which the obtaining the digallium trioxide single crystal is performed is an inert gas atmosphere. The crucible includes a seed-crystal placing portion having a cylindrical shape, a diameter increasing portion connected to the seed-crystal placing portion, and a straight body portion connected to the diameter increasing portion. The seed-crystal placing portion has a hollow portion that opens on a side connected to the diameter increasing portion and that is provided with a bottom wall on a side opposite to the diameter increasing portion. The diameter increasing portion has a shape in which an area S of a cross section of the diameter increasing portion orthogonal to an axial direction of the crucible increases upward in the axial direction, and is connected to the seed-crystal placing portion on a small-diameter side of the diameter increasing portion. The diameter increasing portion has three or four positions at each of which a ratio S/Z of the area S to a distance Z in the axial direction of the crucible from a connection point between the diameter increasing portion and the seed-crystal placing portion is 157.1 mm. The straight body portion has a hollow cylindrical shape and is connected to a large-diameter side of the diameter increasing portion. The plate-shaped member has a plurality of through-holes each extending through the plate-shaped member in a direction parallel to the axial direction in a state in which the plate-shaped member is disposed on the digallium trioxide melt. An area proportion of the plurality of through-holes occupying a cross section of the plate-shaped member orthogonal to the axial direction is 0.12 to 0.28. A unit of the distance Z is mm, a unit of the area S is mm², and a unit of S/Z is mm. The method of manufacturing the digallium trioxide single crystal having such characteristics can obtain a digallium trioxide single crystal for obtaining a digallium trioxide single-crystal substrate that is less likely to crack.
[6] A method of manufacturing a digallium trioxide single-crystal substrate according to one aspect of the present disclosure includes obtaining a digallium trioxide single-crystal substrate having a circular main surface by processing the digallium trioxide single crystal obtained by the method of manufacturing a digallium trioxide single crystal. The method of manufacturing the digallium trioxide single-crystal substrate having such characteristics can obtain a digallium trioxide single-crystal substrate that is less likely to crack.
[7] In the digallium trioxide single-crystal substrate according to [2], a dislocation density of the central portion is preferably 100 cm⁻² or less. The digallium trioxide single-crystal substrate preferably includes a dopant. The dopant is preferably tin. The atomic concentration of the dopant is preferably 2 × 10¹⁹ cm⁻³ or less. As a result, the digallium trioxide single-crystal substrate including tin as a dopant is less likely to be cracked and has a low density of defects in the single crystal, and thus can have high quality.

### [Details of Embodiment]

Hereinafter, one embodiment according to the present disclosure (hereinafter, also referred to as "the embodiment") will be described in more detail, but the present disclosure is not limited thereto. In the following description, the same or corresponding elements are denoted by the same reference characters throughout the specification and the drawings, and a description thereof will not be repeated. Further, in the drawings, the scale of each component is appropriately adjusted for easy understanding, and the scale of each component shown in the drawings does not necessarily match the actual scale of the component.

In the present specification, the expression in the form of "A to B" means the upper limit and the lower limit of the range (that is, A or more and B or less), and in a case where units are not described in A and units are described only in B, the units of A and the units of B are the same. Further, in the present specification, when a compound or the like is represented by a chemical formula, all conventionally known atomic ratios are included unless the atomic ratio is particularly limited, and the atomic ratio should not necessarily be limited to those within the stoichiometric range.

In the present specification, the "main surface" of the digallium trioxide single-crystal substrate means both of the two circular surfaces of the digallium trioxide single-crystal substrate. The digallium trioxide single-crystal substrate is within the scope of the present disclosure if at least one of the two surfaces meets the claims of the present disclosure. Further, in the present specification, the term "plane" used in the term "in-plane" means "main surface". Furthermore, when the diameter of the digallium trioxide single-crystal substrate is described as "100 mm", it means that the diameter is around 100 mm (about 95 to 105 mm), or means that the diameter is 4 inches. When the diameter is described as "150 mm", it means that the diameter is around 150 mm (about 145 to 155 mm), or means that the diameter is 6 inches. The diameter can be measured by using a conventionally known outer diameter measuring instrument such as a caliper.

In the present specification, the "nanoindentation hardness" means indentation hardness obtained by performing instrumented indentation testing in accordance with ISO14577, which is an international standard including the nanoindentation method (Ryo Nitake, "Mechanical property evaluation method using nanoindenter", Bunseki, 561 (2021), pp. 457 to 461). To be specific, the hardness means a hardness obtained by performing indentation testing on a predetermined position on the main surface of the digallium trioxide single-crystal substrate using a Berkovich indenter according to a nanoindentation method to obtain a load displacement curve, and analyzing the load displacement curve. The "nanoindentation hardness" is determined by dividing the maximum load (mN) applied to the digallium trioxide single-crystal substrate with a Berkovich indenter by the area (mm²) where the Berkovich indenter was in contact with the digallium trioxide single-crystal substrate when the maximum load was applied. The unit of the "nanoindentation hardness" is Pascal (Pa).

In the present specification, the terms "dislocation" and "dislocation density" mean "threading dislocation" and "the number of threading dislocations per cm² of the main surface", respectively, which are identified by applying a processing method described later to the main surface. The "threading dislocation" is known as one aspect of a crystal defect.

In the crystallographic description in this specification, an individual orientation is indicated by [], a group orientation is indicated by <>, an individual plane is indicated by (), and a group plane is indicated by {}. Further, a negative index in crystallography is usually expressed by attaching "- (bar)" above a number, but in the present specification, a negative sign is attached before a number.

### [Digallium Trioxide Single-Crystal Substrate]

The digallium trioxide single-crystal substrate (Ga₂O₃ single-crystal substrate) according to the embodiment is a Ga₂O₃ single-crystal substrate including a circular main surface. The diameter of the Ga₂O₃ single-crystal substrate is 100 mm or more. The main surface is a (001) surface of a digallium trioxide single crystal (Ga₂O₃ single crystal) constituting the Ga₂O₃ single-crystal substrate. The main surface has a central portion including a center of the main surface and an outer peripheral portion surrounding an outer periphery of the central portion. The outer peripheral portion is a chamfered region. The first nanoindentation hardnesses measured at nine positions on the main surface in accordance with a nanoindentation method using a Berkovich indenter are each 13 GPa to 20 GPa under a first condition in which a maximum load is set to 10 mN and a load is applied such that a crossing angle between one side of an indentation and a direction in which a [100] direction of the Ga₂O₃ single crystal is projected on the main surface is 0° to 10°. When a length from the center of the main surface to a boundary between the central portion and the outer peripheral portion is r, two axes passing through the center and orthogonal to each other on the main surface are an X-axis and a Y-axis, and the Y-axis is a b-axis of the Ga₂O₃ single crystal, coordinates (X, Y) of the X-axis and the Y-axis of the nine positions are (0, 0), (r-5, 0), (0, r-5), (-(r-5), 0), (0, -(r-5)), (r-1, 0), (0, r-1), (-(r-1), 0), and (0, -(r-1)). The units of r and X and Y in the coordinates (X, Y) are mm. The Ga₂O₃ single-crystal substrate having such characteristics may have a property of being less likely to be cracked. Hereinafter, unless otherwise specified, the "Ga₂O₃ single-crystal substrate" and the "Ga₂O₃ single crystal" in the present specification mean the "beta type Ga₂O₃ single-crystal substrate" and the "beta type Ga₂O₃ single crystal", respectively.

The present inventors presume that the reason why the Ga₂O₃ single-crystal substrate can have a property of being less likely to crack is as follows. That is, in a Ga₂O₃ single-crystal substrate having a Ga₂O₃ single crystal with a (001) plane as a main surface, the (001) plane is generally a plane having strong cleavage properties, and thus it is known that cracks and the like are likely to occur due to external stresses, and thus the substrate is likely to crack. In contrast, in the Ga₂O₃ single-crystal substrate according to the embodiment, the main surface is the (001) plane of the Ga₂O₃ single crystal constituting the Ga₂O₃ single-crystal substrate, and the Ga₂O₃ single crystal is manufactured based on the method described in the item of "Method of manufacturing digallium trioxide single crystal" described later. That is, the Ga₂O₃ single crystal is crystal grown at a stable rate using a predetermined single crystal growth apparatus, so that the defect concentration in the crystal becomes uniform without deviation. Thus, the Ga₂O₃ single crystal may have uniform hardness without variation in the crystal. Further, the main surface of the Ga₂O₃ single-crystal substrates obtained from the Ga₂O₃ single crystal can also be uniform with an in-plane considerable degree of hardness without variation. The fact that the in-plane hardness of the main surface is uniform without variation means that starting points of fracture such as cracks are less likely to be formed in the main surface. From the above, it is considered that the Ga₂O₃ single-crystal substrate according to the embodiment can have a property of being less likely to crack because the starting points of fracture such as cracks are less likely to be formed in the main surface.

### <Diameter>

The diameter of the Ga₂O₃ single-crystal substrate is 100 mm or more. In particular, the diameter of the Ga₂O₃ single-crystal substrate is preferably 99.5 mm to 152 mm. The Ga₂O₃ single-crystal substrate having a diameter of 99.5 mm to 152 mm is preferably a Ga₂O₃ single-crystal substrate, specifically, having a diameter of 100 mm or 150 mm, in other words, a Ga₂O₃ single-crystal substrate having a diameter of 4 inches or 6 inches. This makes it possible to provide a characteristic of being less likely to crack in a large-diameter Ga₂O₃ single-crystal substrate having a diameter of 99.5 mm to 152 mm. Here, the diameter of the Ga₂O₃ single-crystal substrate is determined based on the circular shape before the orientation flat (hereinafter, also referred to as "OF"), the index flat (hereinafter, also referred to as "IF"), and the like are formed even when the main surface does not have a geometric circular shape due to the influence of the OF, the IF, and the like. Further, as described above, the diameter of the Ga₂O₃ single-crystal substrate can be measured by using a conventionally known outer diameter measuring device such as a caliper.

### <Main Surface>

### (Circular Shape)

The Ga₂O₃ single-crystal substrate according to the embodiment has a circular main surface as described above. In the present specification, the "circular shape" representing the shape of the main surface includes a geometric circular shape, and also includes a shape in which the main surface does not form a geometric circular shape due to at least one of a notch, an OF, or an IF being formed in the outer periphery of the main surface. Here, the "shape in which the main surface does not form a geometric circular shape" means a shape in which a length of a line segment extending from any point on the notch, OF, and IF to the center of the main surface among line segments extending from any point on the outer periphery of the main surface to the center of the main surface is shortened. Further, the "shape in the case where the main surface does not form a geometric circular shape" also includes a shape in the case where the lengths of all line segments extending from any point on the outer periphery of the main surface to the center of the main surface are not necessarily identical due to the shape of the Ga₂O₃ single crystal which is a material of the Ga₂O₃ single-crystal substrate. In this case, the center of the main surface refers to the position of the center of gravity, and the diameter of the Ga₂O₃ single-crystal substrate refers to the length of the longest line segment among line segments extending from any point on the outer periphery of the Ga₂O₃ single-crystal substrate to another point on the outer periphery through the center of the main surface.

### ((001) Plane of Ga₂O₃ Single Crystal)

The main surface is a (001) surface of a Ga₂O₃ single crystal constituting the Ga₂O₃ single-crystal substrate. As disclosed in the above-mentioned Patent Literature 1, the (001) plane of the Ga₂O₃ single crystal is a strong cleavage plane next to the (100) plane, and is generally considered that cracks or the like are easily generated by external stress, and is easily cracked. However, in the Ga₂O₃ single-crystal substrate, the in-plane hardness of the main surface is uniform without variation as described above, and thus the starting points of fracture such as cracks are less likely to be formed in the main surface.

In the present disclosure, the crystal surface of the main surface has an accuracy error of ± 0.5°. For example, when the main surface is a "(001) plane" of a Ga₂O₃ single crystal, it means that the main surface has a possibility to be a (001) just plane, or the main surface has a possibility to be a plane having an off angle of -0.5 to +0.5° from the (001) plane. The off angle from the (001) plane in the main surface of the Ga₂O₃ single-crystal substrate can be measured by using a conventionally known crystal orientation measurement device (for example, trade name (product number): "2991G2", manufactured by Rigaku Corporation).

### (Central Portion and Outer Peripheral Portion)

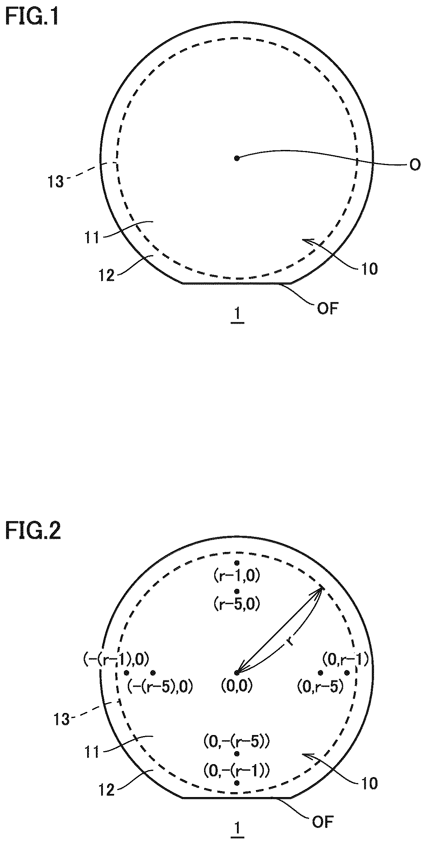

FIG. 1 is an explanatory diagram illustrating a main surface of a Ga₂O₃ single-crystal substrate according to the embodiment. As shown in FIG. 1, a main surface 10 of a Ga₂O₃ single-crystal substrate 1 includes a central portion 11 that includes the center, and an outer peripheral portion 12 that surrounds the outer periphery of the central portion 11. The central portion 11 is a region in which epitaxial layers for constituting electronic devices are stacked in the Ga₂O₃ single-crystal substrate 1. The outer peripheral portion 12 is a chamfered region. By chamfering the outer peripheral portion 12, the Ga₂O₃ single-crystal substrate 1 can reduce the occurrence of cracking and chipping at the outer edge of the outer peripheral portion 12 when being handled. The chamfering process for the outer peripheral portion 12 can be performed by a conventionally known method.

The central portion 11 preferably has a circular shape. Thus, the length from a center O of the main surface 10 to a boundary 13 between the central portion 11 and the outer peripheral portion 12 can be expressed by one predetermined numerical value "r". Here, the "circular shape" representing the shape of the central portion 11 includes a geometric circular shape, and also includes a shape in a case where a geometric circular shape such as a substantially circular shape is not formed due to chamfering process or the like on the outer peripheral portion 12. In this case, the length r from the center O of the main surface 10 to the boundary 13 between the central portion 11 and the outer peripheral portion 12 refers to the length of the shortest line segment among the line segments extending from the center O of the main surface 10 to the boundary 13 between the central portion 11 and the outer peripheral portion 12. The shape of the central portion 11 may be a polygonal shape such as a triangular shape, a quadrangular shape, or a hexagonal shape.

The width of the outer peripheral portion 12 may be 2 to 5 mm, that is, a length from an outer edge of the outer peripheral portion 12 to the boundary 13 between the central portion 11 and the outer peripheral portion 12. This is because the region of the above-described outer peripheral portion 12 of the Ga₂O₃ single-crystal substrate 1 is a region which is not usually used as a material for semiconductor integrated circuit devices, because it is known that there is a possibility that processing strain during chamfering process remains in the region, and the number of dislocations greatly varies from substrate to substrate and the flatness is poor.

The central portion 11 and the outer peripheral portion 12 are distinguished from each other by a difference in thickness of the Ga₂O₃ single-crystal substrate 1 at these portions. The thickness of the Ga₂O₃ single-crystal substrate 1 in the outer peripheral portion 12 is less than 99% of the thickness of the Ga₂O₃ single-crystal substrate 1 in the central portion 11. That is, the outer peripheral portion 12 means a region which is chamfered as described above and in which the thickness in the region is less than 99% of the thickness in the central portion 11. For example, when the thickness of the central portion 11 is 675 µm, the thickness of the outer peripheral portion 12 is 668 µm or less. The thickness of each of the central portion 11 and the outer peripheral portion 12 can be measured by using a noncontact thickness meter (trade name (model): "TAP-2H-200XY", manufactured by Coms Co., Ltd.). The positioning accuracy of the measuring device is 25 µm. The display resolution of the measuring device is 0.01 µm. The repeatability of the instrument is 0.01 µm. The measuring device used for measuring the thickness of the central portion 11 and the outer peripheral portion 12 is not limited to the above measuring device, and other measuring devices may be used as long as the positioning accuracy, the display resolution, and the repetition accuracy are equal to or higher than those of the above measuring device. In the present specification, the "thickness of the Ga₂O₃ single-crystal substrate 1 of the central portion 11" means the thickness of the center O of the main surface 10 of the Ga₂O₃ single-crystal substrate 1. Thus, "r", which is the length from the center O of the main surface 10 to the boundary 13 between the central portion 11 and the outer peripheral portion 12, can be obtained as a specific numerical value (unit: mm).

### (Nanoindentation Hardness)

In the Ga₂O₃ single-crystal substrate, the first nanoindentation hardnesses measured at nine positions on the main surface in accordance with a nanoindentation method using a Berkovich indenter are each 13 GPa to 20 GPa under a first condition in which a maximum load is set to 10 mN and a load is applied such that a crossing angle between one side of an indentation and a direction in which a [100] direction of the Ga₂O₃ single crystal is projected on the main surface is 0° to 10°. When a length from the center of the main surface to a boundary between the central portion and the outer peripheral portion is r, two axes passing through the center and orthogonal to each other on the main surface are an X-axis and a Y-axis, and the Y-axis is a b-axis of the Ga₂O₃ single crystal, coordinates (X, Y) of the X-axis and the Y-axis of the nine positions are (0, 0), (r-5, 0), (0, r-5), (-(r-5), 0), (0, - (r-5)), (r-1, 0), (0, r-1), (-(r-1), 0), and (0, -(r-1)). The units of r and X and Y in the coordinates (X, Y) are mm. Each of the first nanoindentation hardnesses measured at nine positions on the main surface is preferably more than 13 GPa and 14 GPa or less. The difference between the maximum and minimum values of the first nanoindentation hardnesses measured at the nine positions on the main surface is preferably less than 0.7 GPa, and more preferably 0.5 GPa or less. The difference between the maximum value and the minimum value of the first nanoindentation hardnesses measured at the nine positions on the main surface is most preferably 0 (zero).

Further, it is preferable that the second nanoindentation hardnesses measured at nine positions in accordance with the nanoindentation method are each 15 GPa to 20 GPa under a second condition in which the maximum load is set to 1mN and the load is applied such that the crossing angle between the one side of the indentation and the direction in which the [100] direction of the Ga₂O₃ single crystal is projected on the main surface is 0° to 10° . This makes it possible to provide a Ga₂O₃ single-crystal substrate which is less likely to crack. Each of the second nanoindentation hardnesses measured at nine positions on the main surface is preferably more than 15 GPa and 16 GPa or less. The difference between the maximum and minimum values of the second nanoindentation hardnesses measured at the nine positions on the main surface is preferably less than 0.7 GPa, and more preferably 0.5 GPa or less. The difference between the maximum value and the minimum value of the second nanoindentation hardnesses measured at the nine positions on the main surface is most preferably 0 (zero).

FIG. 2 is an explanatory diagram illustrating measurement points at nine positions set on the main surface of the Ga₂O₃ single-crystal substrate of FIG. 1 to obtain first and second nanoindentation hardnesses. Hereinafter, a method of measuring the first nanoindentation hardnesses and the second nanoindentation hardnesses measured at the nine positions on the main surface 10 in accordance with the nanoindentation method using a Berkovich indenter will be described with reference to FIG. 2. In the following description, a measurement method for obtaining the first nanoindentation hardnesses will be specifically exemplified. The measurement method can be performed by using, for example, a nanoindenter (trade name: "Bruker Hysitron TI980 Triboindenter", manufactured by Bruker Japan Co., Ltd.).

### 1) Preliminary Measurement

First, preliminary measurement is performed on the Ga₂O₃ single-crystal substrate 1 so as to apply a load such that the crossing angle between one side of the indentation of the Berkovich indenter and the direction in which the [100] direction of the Ga₂O₃ single crystal is projected on the main surface is 0° to 10°. First, the Ga₂O₃ single-crystal substrate 1 is fixed to the sample stage of the nanoindenter. Next, the Ga₂O₃ single-crystal substrate 1 on the sample stage is observed using an optical system provided in the nanoindenter, whereby, for example, any position of the central portion 11 on the main surface 10 is designated as a measured position. As the measured position, it is preferable to designate a position other than the above-described nine positions on the main surface 10 (that is, position other than (0,0), (r-5, 0), (0, r-5), (- (r-5), 0), (0, - (r-5)), (r-1, 0), (0, r-1), (- (r-1), 0), and (0, - (r-1)), which are coordinates (X, Y) of the nine positions) in order to contribute to the main measurement described later. Further, a Berkovich indenter is moved to the measured positions, indentation testing is performed at a maximum load 10mN, and then the Ga₂O₃ single-crystal substrate 1 is taken out from the sample stage. At this time, since the indentation of the Berkovich indenter is formed at the measured position, it is possible to obtain the crossing angle between one side of the indentation and the [100] direction of the Ga₂O₃ single crystal constituting the Ga₂O₃ single-crystal substrate 1. The crossing angle can be determined by a conventionally known method.

### 2) Main Measurement

Next, the main measurement for obtaining the first nanoindentation hardnesses is performed. When the crossing angle obtained in the preliminary measurement is 0° to 10°, the Ga₂O₃ single-crystal substrate 1 is fixed to the sample stage in the same direction as that in the preliminary testing. When the crossing angle determined in the preliminary measurement is more than 10°, the orientation of the Ga₂O₃ single-crystal substrate 1 is adjusted so that the crossing angle is 0° to 10°, and then the Ga₂O₃ single-crystal substrate 1 is fixed to the sample stage. Further, the Ga₂O₃ single-crystal substrate 1 on the sample stage is observed using the optical system provided in the nanoindenter, whereby one (for example, (0,0)) of the coordinates (X, Y) of the above-described nine positions on the main surface 10 is designated as the measured position. Subsequently, the Berkovich indenter is moved to the measured position (for example, (0, 0)), and after indentation testing is performed at the maximum load 10mN, the Ga₂O₃ single-crystal substrate 1 is taken out from the sample stage. At this time, the Berkovich indenter indentation is formed at the measured positions. Thus, based on the indentation, the area (mm²) where the Berkovich indenter was in contact with the Ga₂O₃ single-crystal substrate 1 when the maximum load 10mN was applied can be calculated, and the first nanoindentation hardnesses at the measured positions (for example, (0, 0)) can be obtained by dividing the maximum load 10mN by the area (mm²).

Subsequently, the remainder (for example, (r-5, 0), (0, r-5), (-(r-5), 0), (0, -(r-5)), (r-1, 0), (0, r-1), (-(r-1), 0), and (0, -(r-1)) of the coordinates (X, Y) of the above-described nine positions on the main surface 10 are designated as the measured positions. Thereafter, the indentation testing is performed in the same manner as in the case where the above-described (0,0) is designated as the measured position, and a predetermined calculation is performed, whereby the first nanoindentation hardnesses in the remainder of the coordinates (X, Y) of the above-described nine positions on the main surface 10 can be obtained.

Further, the second nanoindentation hardnesses can be determined in the same manner as the first nanoindentation hardnesses are determined, except that the maximum load of the indentation testing described above is used as the 1mN. In the Ga₂O₃ single-crystal substrate according to the embodiment, the first nanoindentation hardnesses measured at nine positions on the main surface by the above-described measurement method are each 13 GPa to 20 GPa. Thus, the Ga₂O₃ single-crystal substrate has a main surface with a considerably high hardness in-plane and uniform without variation. Further, the second nanoindentation hardnesses measured at nine positions on the main surface are each preferably from the 15 GPa to the 20 GPa. In this case, the main surface of the Ga₂O₃ single-crystal substrate may have a considerably high hardness in-plane and may be more uniform without variation.

Here, the first nanoindentation hardness is indentation hardness obtained by performing indentation testing at a maximum load 10mN. The second nanoindentation hardness is indentation hardness determined by performing indentation testing in a maximum load 1mN. When indentation testing is performed in the maximum load 10mN, it is considered that the Berkovich indenter is more deeply indented into the Ga₂O₃ single-crystal substrate to form an indentation, compared to when indentation testing is performed in the maximum load 1mN. Thus, it can be considered that the first nanoindentation hardness reflects the indentation hardness of the inside of the Ga₂O₃ single-crystal substrate, compared to the second nanoindentation hardness. It can be considered that the second nanoindentation hardness reflects the indentation hardness of the Ga₂O₃ single-crystal substrate in the vicinity of the main surface as compared with the first nanoindentation hardness.

### <Dislocation Density>

In the Ga₂O₃ single-crystal substrate according to the embodiment, the dislocation density of the central portion is preferably 100 cm⁻² or less. The dislocation density of the central portion is more preferably 50 cm⁻² or less. Thus, a digallium trioxide single-crystal substrate having a low density of defects in the Ga₂O₃ single crystal and thus having high quality can be provided. The lower limit value of the dislocation density of the central portion is 0 cm⁻² as an ideal value. A practical lower limit value of the dislocation density of the central portion is, for example, 10 cm⁻².

Specifically, the dislocation density of the central portion is determined by counting corrosion pits (hereinafter also referred to as "etch-pits") that appear in the central portion of the main surface after etching of the main surface using an 85 mass% phosphoric acid solution. That is, in the Ga₂O₃ single-crystal substrate according to the embodiment, it is preferable that the etch-pit concentration in the central portion of the main surface is 100 cm⁻² or less. Although etch-pit is not scientifically synonymous with dislocation, it can be considered as equivalent to dislocation in the present technical field.

### (Method of Calculating Number of Etch-Pits)

First, the main surface of the Ga₂O₃ single-crystal substrate is immersed in 85 mass% phosphoric acid at 190°C for 30 minutes. Subsequently, the Ga₂O₃ single-crystal substrate is taken out from the phosphoric acid. As a method of immersing the Ga₂O₃ single-crystal substrate, a conventionally known method can be used. This results in a Ga₂O₃ single-crystal substrate in which dislocations present in the main surface, particularly on the central portion, appear as etch-pits.

Next, an imaginary lattice is set by laying out the largest number of squares each having a side of 1 mm on the central portion of the Ga₂O₃ single-crystal substrate so as to be arranged in parallel without overlapping each other. Further, each of the squares constituting the imaginary lattice is observed with a known optical microscope (for example, trade name: "ECLIPSE (registered trade name) LV150N", manufactured by Nikon Corporation), and the number of etch-pits appearing in one field of view of the optical microscope is counted. In this case, the observation with the optical microscope is performed at a magnification of 100 times. Thus, one field of view of the optical microscope has a size of 1 mm × 1 mm, which corresponds to the size of the square. Thus, the number of etch-pits per field of view is determined as the number of dislocations per square constituting the imaginary lattice. As the number of etch-pits, only etch-pits whose area is confirmed to be 100 µm² or more are counted.

Finally, the etch-pits counted for each square constituting the imaginary lattice are converted into the number per cm². Thus, the dislocation density of each square is calculated. Subsequently, the total sum of the dislocation densities is divided by the number of squares, thereby obtaining the dislocation density of the central portion. In the present specification, "the largest number of squares are laid on the central portion so as to be arranged in parallel without overlapping each other" on the central portion means that, in a case where the squares are laid on the central portion so as to be arranged in parallel without overlapping each other, when the squares overlaps the outer peripheral portion and the outer edge thereof, the squares are excluded as elements constituting the imaginary lattice. This is because the region near the outer periphery including the outer peripheral portion of the Ga₂O₃ single-crystal substrate has a large variation in the number of dislocations for each substrate and is usually a region that is not used as a material of semiconductor element.

### <Dopant>

The Ga₂O₃ single-crystal substrate according to the embodiment preferably includes a dopant. The dopant is preferably tin (Sn) or silicon (Si). The atomic concentration of the dopant is preferably 2 × 10¹⁹ cm⁻³ or less. This makes it possible to impart n-type (electrondonating) characteristics as a conductivity type to the Ga₂O₃ single-crystal substrate, and to provide the Ga₂O₃ single-crystal substrate including a dopant with characteristics that make the substrate less likely to crack.

The atomic concentration of Sn or Si in the Ga₂O₃ single-crystal substrate is measured by using Glow Discharge Mass Spectrometry (GDMS). The Ga₂O₃ single-crystal substrate including the dopant can be obtained by adding a predetermined amount of the dopant to a crucible together with a digallium trioxide bulk body (hereinafter, also referred to as "Ga₂O₃ bulk body") or the like as a raw material when the Ga₂O₃ single-crystal substrate is obtained from a Ga₂O₃ single crystal obtained by a method of manufacturing a Ga₂O₃ single crystal as described below. The dopant is preferably tin (Sn). The atomic concentration of the dopant is more preferably 1 × 10¹⁷ cm⁻³ to 2 × 10¹⁹ cm⁻³.

### [Method of Manufacturing Digallium Trioxide Single Crystal]

The method of manufacturing the digallium trioxide single crystal (Ga₂O₃ single crystal) according to the embodiment is preferably, for example, the method of manufacturing of the Ga₂O₃ single crystal constituting the Ga₂O₃ single-crystal substrate having the circular main surface described above. The method of manufacturing the Ga₂O₃ single crystal may include the following steps. That is, the method of manufacturing includes preparing a single crystal growth apparatus (hereinafter, also referred to as a "Ga₂O₃ single crystal growth apparatus") including at least a crucible having a cylindrical shape and a heating device disposed so as to surround an outer periphery of the crucible, placing a seed crystal in a bottom portion of the crucible, and placing a digallium trioxide bulk body (Ga₂O₃ bulk body) that is in the form of a lump, a plate-shaped member composed of pyrolytic boron nitride (pBN), and boron oxide in a solid state (B₂O₃) in that order above the seed crystal in the crucible, by heating the crucible by the heating device to melt the Ga₂O₃ bulk body and a portion of the seed crystal, obtaining a digallium trioxide melt (Ga₂O₃ melt) and bringing the Ga₂O₃ melt into contact with a remaining portion of the seed crystal, and obtaining the Ga₂O₃ single crystal by growing a crystal from the Ga₂O₃ melt on the remaining portion of the seed crystal. The bringing the Ga₂O₃ melt into contact with the remaining portion of the seed crystal includes disposing the plate-shaped member on the Ga₂O₃ melt and turning the B₂O₃ into liquid. The atmosphere in which the obtaining the Ga₂O₃ single crystal is performed is an inert gas atmosphere.

Further, the crucible includes a seed-crystal placing portion having a cylindrical shape, a diameter increasing portion connected to the seed-crystal placing portion, and a straight body portion connected to the diameter increasing portion. The seed-crystal placing portion has a a hollow portion that opens on a side connected to the diameter increasing portion and that is provided with a bottom wall on a side opposite to the diameter increasing portion. The diameter increasing portion has a shape in which an area S of a cross section of the diameter increasing portion orthogonal to an axial direction of the crucible increases upward in the axial direction, and is connected to the seed-crystal placing portion on a small-diameter side of the diameter increasing portion. The diameter increasing portion has three or four positions at each of which a ratio S/Z of the area S to a distance Z in the axial direction of the crucible from a connection point between the diameter increasing portion and the seed-crystal placing portion is 157.1 mm. The straight body portion has a hollow cylindrical shape and is connected to a large-diameter side of the diameter increasing portion. The plate-shaped member has a plurality of through-holes each extending through the plate-shaped member in a direction parallel to the axial direction in a state in which the plate-shaped member is disposed on the Ga₂O₃ melt. An area proportion of the plurality of through-holes occupying a cross section of the plate-shaped member orthogonal to the axial direction is 0.12 to 0.28. The unit of the distance Z is mm, the unit of the area S is mm², and the unit of S/Z is mm. By the method of manufacturing a Ga₂O₃ single crystal having such characteristics, a Ga₂O₃ single crystal constituting a Ga₂O₃ single-crystal substrate which is less likely to crack can be obtained.

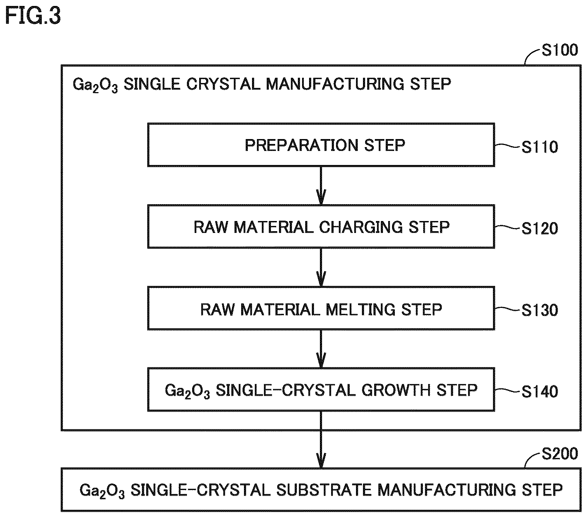

FIG. 3 is a flowchart showing an example of a method of manufacturing a Ga₂O₃ single-crystal substrate including a method of manufacturing a Ga₂O₃ single crystal according to the embodiment. The method of manufacturing of the Ga₂O₃ single crystal according to the embodiment is preferably included in the method of manufacturing of the Ga₂O₃ single-crystal substrate as, for example, a Ga₂O₃ single-crystal manufacturing step S100 shown in the flowchart of FIG. 3. Referring to FIG. 3, the method of manufacturing a Ga₂O₃ single-crystal substrate according to the embodiment includes the Ga₂O₃ single-crystal manufacturing step S100 and a Ga₂O₃ single-crystal substrate manufacturing step S200. The Ga₂O₃ single-crystal manufacturing step S100 includes a step of preparing a Ga₂O₃ single crystal growth apparatus including at least a crucible having a cylindrical shape and a heating device disposed so as to surround an outer periphery of the crucible (first step: a preparation step S110). In the preparation step S110, in addition to the Ga₂O₃ single crystal growth apparatus, a seed crystal, a Ga₂O₃ bulk body that is in the form of a lump, a plate-shaped member composed of pBN, and B₂O₃ in a solid state are preferably prepared. The Ga₂O₃ single-crystal manufacturing step S100 includes a step of placing the seed crystal in the bottom portion of the crucible, and placing the Ga₂O₃ bulk body, the plate-shaped member, and the B₂O₃ in that order above the seed crystal in the crucible (second step: a raw material charging step S120). The Ga₂O₃ single-crystal manufacturing step S100 includes a step of, by heating the crucible by the heating device to melt the Ga₂O₃ bulk body and a portion of the seed crystal, obtaining a Ga₂O₃ melt and bringing the Ga₂O₃ melt into contact with a remaining portion of the seed crystal (third step: a raw material melting step S130). The raw material melting step S130 preferably includes a step of disposing the plate-shaped member on the Ga₂O₃ melt and turning the B₂O₃ into liquid. Further, the Ga₂O₃ single-crystal manufacturing step S100 includes a step of obtaining the Ga₂O₃ single crystal by growing a crystal from the Ga₂O₃ melt on the remaining portion of the seed crystal (fourth step: Ga₂O₃ single-crystal growth step S140). An atmosphere in which the Ga₂O₃ single-crystal growth step S140 is performed is preferably an inert gas atmosphere.

The present inventors have focused on the structure of the diameter increasing portion of the crucible constituting the Ga₂O₃ single crystal growth apparatus for crystal growth of the Ga₂O₃ single crystal constituting the Ga₂O₃ single-crystal substrate having the above-described characteristics. Specifically, the shape of the side surface of the diameter increasing portion having a shape in which the area S of the cross section of the diameter increasing portion orthogonal to the axial direction of the crucible increases from the lower side to the upper side of the crucible is a shape similar to a polygon in a crosssectional view parallel to the axial direction. More particularly, the diameter increasing portion has a structure having three or four positions at each of which a ratio S/Z of the area S to a distance Z in the axial direction of the crucible from a connection point between the diameter increasing portion and the seed-crystal placing portion is 157.1 mm. Thus, when the Ga₂O₃ single-crystal growth step S140 was performed, the shape of the interface between the Ga₂O₃ melt and the crystal (Ga₂O₃ single crystal) in the diameter increasing portion was a circular shape orthogonal to the axial direction of the crucible and a shape that was not substantially uneven along the axial direction (hereinafter, also simply referred to as a "flat shape"). As a result, the inventors have found that the growth rate of the Ga₂O₃ single crystal grown in the diameter increasing portion is stabilized, and thus the Ga₂O₃ single crystal having a uniform crystal defect concentration without deviation can be obtained. According to the Ga₂O₃ single crystal, a Ga₂O₃ single-crystal substrate having a main surface with the predetermined hardness in-plane and uniform without variation can be obtained. Thus, the starting points of fracture such as cracks are hardly formed in the main surface from the Ga₂O₃ single crystal, and thus a Ga₂O₃ single-crystal substrate which is less likely to crack can be obtained. As described above, the present inventors have conceived a method of manufacturing a Ga₂O₃ single crystal according to the embodiment.

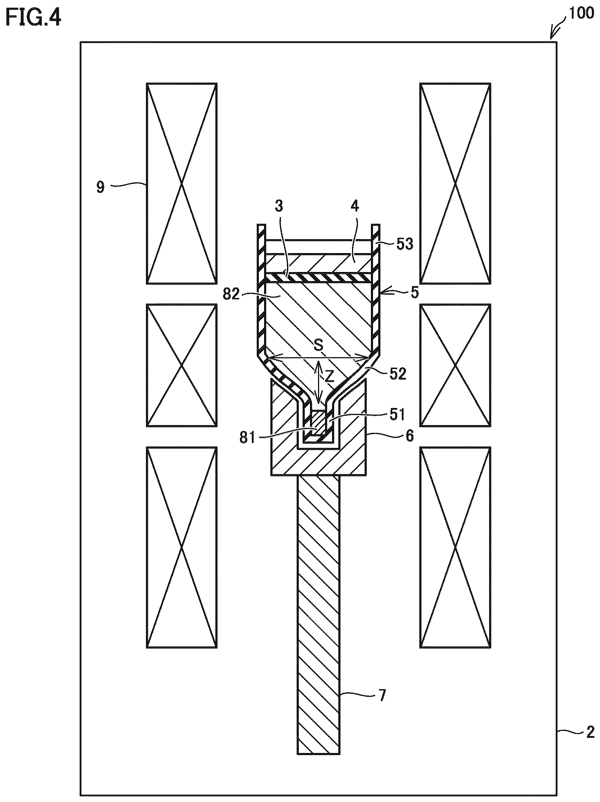

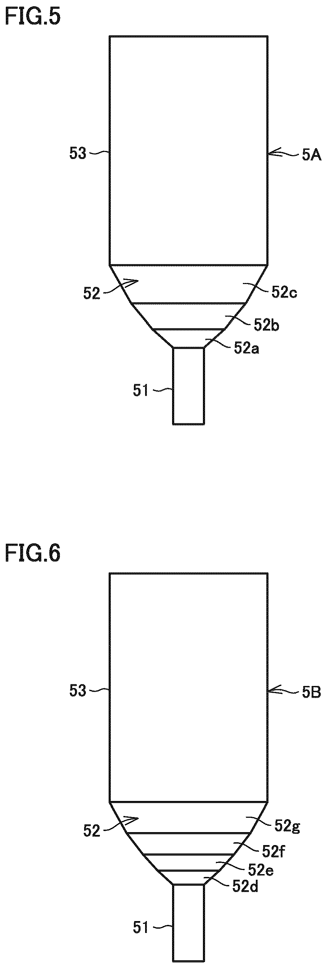

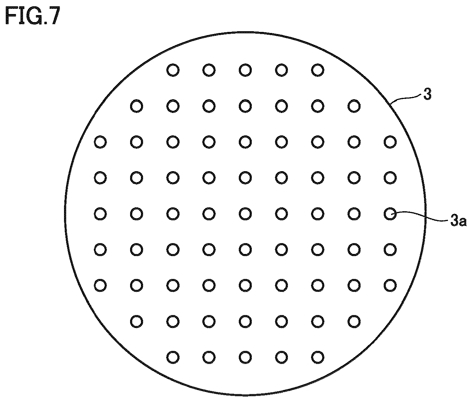

Hereinafter, an overview of the Ga₂O₃ single crystal growth apparatus and the Ga₂O₃ single-crystal manufacturing step S 100 will be described respectively with reference to FIG. 3 and FIGS. 4 to 7. FIG. 4 is a diagram schematically illustrating a manufacturing apparatus used in the method of manufacturing a Ga₂O₃ single crystal according to the embodiment. FIG. 5 is an explanatory diagram illustrating one embodiment (first crucible) of a crucible included in the manufacturing apparatus used in the method of manufacturing a Ga₂O₃ single crystal according to the embodiment. FIG. 6 is an explanatory diagram illustrating another embodiment (second crucible) of the crucible included in the manufacturing apparatus used in the method of manufacturing a Ga₂O₃ single crystal according to the embodiment. FIG. 7 is an explanatory diagram illustrating, as a plan view, one embodiment of a plate-shaped member included in the manufacturing apparatus used in the method of manufacturing a Ga₂O₃ single crystal according to the embodiment. In the method of manufacturing a Ga₂O₃ single crystal according to the embodiment (Ga₂O₃ single-crystal manufacturing step S 100), a Ga₂O₃ single crystal growth apparatus 100 shown in FIG. 4 is used, for example. The Ga₂O₃ single crystal growth apparatus 100 may grow a single crystal by a vertical boat method using a crucible 5. Hereinafter, the vertical boat method is abbreviated as a VB method. The VB method includes a vertical Bridgman method and a vertical temperature gradient solidification method.

### <Ga₂O₃ Single Crystal Growth Apparatus>

As shown in FIG. 4, the Ga₂O₃ single crystal growth apparatus 100 includes the crucible 5 described above, a crucible holding stage 6 for holding the crucible 5, a lower shaft 7 for supporting the crucible 5 and the crucible holding stage 6, and a heating device 9 for heating the crucible 5. The Ga₂O₃ single crystal growth apparatus 100 includes a plate-shaped member 3 disposed on a Ga₂O₃ melt 82, which is a molten state of the Ga₂O₃ bulk body, in the Ga₂O₃ single-crystal growth step S140. On the plate-shaped member 3, a B₂O₃ for sealing the Ga₂O₃ melt 82 in the crucible 5 is disposed in a liquid state in the Ga₂O₃ single-crystal growth step S 140. In the method of manufacturing a Ga₂O₃ single crystal according to the embodiment, in addition to the Ga₂O₃ single crystal growth apparatus 100, for the purpose of making the atmosphere for executing the Ga₂O₃ single-crystal growth step S140 an atmosphere composed of an inert gas, it is preferable to use a chamber 2 that accommodates contents such as a Ga₂O₃ bulk body accommodated in the crucible 5, the crucible holding stage 6, the lower shaft 7, and the heating device 9. The dimensions, materials, and the like of the chamber 2 are not particularly limited as long as the chamber 2 has a size, materials, and the like that allow the Ga₂O₃ single crystal growth apparatus 100 and the like to be housed and the internal atmosphere to be an atmosphere composed of an inert gas. Further, when the chamber has a good thermal permeability of the sidewall, the heating device of the Ga₂O₃ single crystal growth apparatus may be disposed outside the chamber.

### (Crucible)

As shown in FIG. 4, in the Ga₂O₃ single crystal growth apparatus 100, the crucible 5 includes a seed-crystal placing portion 51 having a cylindrical shape, a diameter increasing portion 52 connected to the seed-crystal placing portion 51, and a straight body portion 53 connected to the diameter increasing portion 52. The seed-crystal placing portion 51 has a cylindrical shape, and has a hollow portion that opens on a side connected to the diameter increasing portion 52 and that is provided with a bottom wall on a side opposite to the diameter increasing portion 52. The seed-crystal placing portion 51 can accommodate and hold a seed crystal 81 in the hollow portion. The diameter increasing portion 52 has a shape in which the area S of a cross section of the diameter increasing portion 52 orthogonal to the axial direction of the crucible 5 increases upward in the axial direction. The diameter increasing portion 52 is connected to the seed-crystal placing portion 51 on a small-diameter side of the diameter increasing portion 52. The straight body portion 53 has a hollow cylindrical shape and is connected to the large-diameter side of the diameter increasing portion 52. In particular, the diameter increasing portion 52 has three or four positions at each of which the ratio S/Z of the area S to the distance Z in the axial direction of the crucible 5 from the connection point between the diameter increasing portion 52 and the seed-crystal placing portion 51 is 157.1 mm. The unit of the distance Z is mm, the unit of the area S is mm², and the unit of S/Z is mm. The shape of the side surface of the diameter increasing portion 52 will be described in detail later. The diameter increasing portion 52 and the straight body portion 53 have functions of holding a Ga₂O₃ bulk body that is in the form of a lump (to be specific, a polycrystal Ga₂O₃) therein. The diameter increasing portion 52 and the straight body portion 53 have a function of growing a Ga₂O₃ single crystal as a crystal by solidifying the Ga₂O₃ melt 82 as described later.

As the crucible 5, various materials that can withstand the temperature of the Ga₂O₃ melt 82 are used. For example, platinum, a platinum alloy including rhodium, or the like may be adopted as the material of the crucible 5. Further, since the atmosphere for executing the Ga₂O₃ single-crystal growth step S140 is an inert gas atmosphere, pBN can also be adopted as the material of the crucible 5. In this case, the manufacturing cost of the Ga₂O₃ single crystal growth apparatus 100 can be reduced. The inner diameter of the straight body portion 53 depends on the diameter of the Ga₂O₃ single crystal to be manufactured, but is, for example, 90 mm to 165 mm. Hereinafter, the shape of the side surface of the diameter increasing portion 52 of the crucible 5 will be described in detail.

### 1) First Crucible

In the method of manufacturing the Ga₂O₃ single crystal, a first crucible 5A as shown in FIG. 5 may be used as one embodiment of the crucible 5 constituting the Ga₂O₃ single crystal growth apparatus 100. The first crucible 5A has the diameter increasing portion 52 having a shape in which the area S of a cross section of the diameter increasing portion 52 orthogonal to the axial direction of the first crucible 5A increases upward in the axial direction. In particular, in the first crucible 5A, the side surface of the diameter increasing portion 52 has three side surface portions. The three side surface portions refer to a lower portion 52a having the largest angle with respect to the axis of the first crucible 5A among the three side surface portions, a middle portion 52b having the second largest angle with respect to the axis of the first crucible 5A among the three side surface portions next to the lower portion 52a, and an upper portion 52c having the smallest angle with respect to the axis of the first crucible 5A among the three side surface portions.

The diameter increasing portion 52 of the first crucible 5A has the above-described three side surface portions, and thus, may have three positions at each of which a ratio S/Z of the area S to the distance Z in the axial direction of the first crucible 5A from the connection point between the diameter increasing portion 52 and the seed-crystal placing portion 51 is 157.1 mm. In detail, each of the lower portion 52a, the middle portion 52b, and the upper portion 52c constituting the three side surface portions may have 1 position, that is, position at which the S/Z is 157.1 mm. Thus, in the diameter increasing portion 52 of the first crucible 5A, the shape of the interface between the Ga₂O₃ melt 82 and the Ga₂O₃ single crystal becomes flat, compared to a conventional diameter increasing portion having a truncated conical shape that increases in size upward in the axial direction of the crucible, and the growth rate of the crystal can be stabilized. In the method of manufacturing the Ga₂O₃ single crystal, the output of the heating device 9 is adjusted as described later, whereby the growth rate of the crystal grown in the straight body portion 53 can be stabilized, and the Ga₂O₃ single crystal having uniform crystal defect densities can be manufactured.

### 2) Second Crucible

In the method of manufacturing the Ga₂O₃ single crystal, a second crucible 5B as shown in FIG. 6 may be used as another embodiment of the crucible 5 constituting the Ga₂O₃ single crystal growth apparatus 100. The second crucible 5B has the diameter increasing portion 52 having a shape in which the area S of a cross section of the diameter increasing portion 52 orthogonal to the axial direction of the second crucible 5B increases upward in the axial direction. In particular, in the second crucible 5B, the side surface of the diameter increasing portion 52 has four side surface portions. The four side surface portions refer to a lowermost portion 52d having the largest angle with respect to the axis of the second crucible 5B among the four side surface portions, a first middle portion 52e having the second largest angle with respect to the axis of the second crucible 5B among the four side surface portions next to the lowermost portion 52d, a second middle portion 52f having the third largest angle with respect to the axis of the second crucible 5B among the four side surface portions next to the lowermost portion 52d and the first middle portion 52e, and an uppermost portion 52g having the smallest angle with respect to the axis of the second crucible 5B among the four side surface portions.

The diameter increasing portion 52 of the second crucible 5B has the above-described four side surface portions, and thus, may have four positions at each of which a ratio S/Z of the area S to the distance Z in the axial direction of the second crucible 5B from the connection point between the diameter increasing portion 52 and the seed-crystal placing portion 51 is 157.1 mm. In detail, each of the lowermost portion 52d, the first middle portion 52e, the second middle portion 52f, and the uppermost portion 52g constituting the four side surface portions may have 1 position, that is, positions having S/Z of 157.1 mm. Thus, in the diameter increasing portion 52 of the second crucible 5B, the shape of the interface between the Ga₂O₃ melt 82 and the Ga₂O₃ single crystal becomes flat, compared to a conventional diameter increasing portion having a truncated conical shape that increases in size upward in the axial direction of the crucible, and the growth rate of the crystal can be stabilized. In the method of manufacturing the Ga₂O₃ single crystal, the output of the heating device 9 is adjusted as described later, whereby the growth rate of the crystal grown in the straight body portion 53 can be stabilized, and the Ga₂O₃ single crystal having uniform crystal defect densities can be manufactured.

### (Crucible Holding Stage)

The Ga₂O₃ single crystal growth apparatus 100 includes the crucible holding stage 6 for holding the crucible 5. The crucible holding stage 6 holds the crucible 5 in contact with the bottom portion of the crucible 5. The crucible holding stage 6 may have a cylindrical appearance. The material of the crucible holding stage 6 is not particularly limited, and quartz, alumina, silicon carbide, or the like can be adopted, for example. The outer diameter of the crucible holding stage 6 depends on the diameter of the crucible 5 to be supported, but is, for example, 75 mm to 200 mm.

### (Lower Shaft)

The lower shaft 7 may support the crucible 5 and the crucible holding stage 6 by supporting the crucible holding stage 6 from below. The lower shaft 7 may be, for example, a circular rod shape in a horizontal cross-section view or a rectangular rod shape in a horizontal cross-section view. As a material of lower shaft 7, for example, molybdenum, carbon, silicon carbide or the like can be employed.

### (Heating Device)

The heating device 9 is installed for the purpose of heating the crucible 5. As the heating device 9, for example, a conventionally known electric heater (hereinafter, also simply referred to as a "heater") can be adopted. The heater is constituted of, for example, two units, and the two units are disposed so as to surround the outer periphery of the crucible 5. The output of the heater may be independently controlled for each unit. In particular, the heater may be configured in multiple stages by being divided into a plurality of portions in a direction perpendicular to the axis of the crucible 5 for each unit. In this case, it is preferable that the output of the heater is independently controlled for each of the portions configured in multiple stages. This allows the temperature of the contents in the crucible 5 to be finely adjusted along the axial direction of the crucible 5. For example, the growth rate of the crystal grown in the straight body portion 53 can be stabilized by independently controlling the output of the heater for each of the portions configured in multiple stages to heat the straight body portion 53.

Although not shown, the Ga₂O₃ single crystal growth apparatus 100 may include a thermoelectric couple capable of measuring the temperature of the crucible 5 heated by the heater. A plurality of thermocouples may be disposed outside the crucible 5 and along the axial direction. As the thermocouple, for example, a known temperature monitor can be adopted.

### (Plate-Shaped Member)

The plate-shaped member 3 is composed of pBN. In the Ga₂O₃ single crystal growth apparatus 100, the plate-shaped member 3 is disposed on the Ga₂O₃ melt 82 for the purpose of preventing the Ga₂O₃ melt 82 from being melted by contact with the B₂O₃ 4 as the liquid sealing material (so-called melting loss). As shown in FIG. 7, the plate-shaped member 3 has a plurality of through-holes 3a each extending through the plate-shaped member 3 in a direction parallel to the axial direction of the crucible 5 in a state in which the plate-shaped member 3 is disposed on the Ga₂O₃ melt 82. An area proportion of the plurality of through-holes 3a occupying a cross section of the plate-shaped member 3 orthogonal to the axial direction is 0.12 to 0.28. Thus, the plate-shaped member 3 can discharge the bubbles generated in the Ga₂O₃ melt 82 to the outside of the crucible 5 or at least to the outside of the system of the Ga₂O₃ melt 82 used for the growth of the crystal through the plurality of through-holes 3a. That is, the plurality of through-hole 3a can inhibit the plate-shaped member 3 from being lifted by the bubbles generated in the Ga₂O₃ melt 82 and from failing to achieve the above-described object. Further, the plate-shaped member 3 can inhibit the bubbles generated in the Ga₂O₃ melt 82 from remaining in the Ga₂O₃ single crystal by the plurality of through-holes 3a.

In the state in which the plate-shaped member 3 is disposed on the Ga₂O₃ melt 82, the area proportion of the plurality of through-holes 3a occupying a cross section of the plate-shaped member 3 orthogonal to the axial direction of the crucible 5 is 0.12 to 0.28 as described above. The area proportion is preferably 0.122 to 0.275. When the area proportion is within the above range, bubbles generated in the Ga₂O₃ melt 82 can be efficiently discharged to the outside of the crystal growth system through the plurality of through-holes 3a.

### <Ga₂O₃ Single-Crystal Manufacturing Step S100>

### (First Step: Preparation Step S110)

As shown in FIG. 3, first, in the Ga₂O₃ single-crystal manufacturing step S 100, a step of preparing a Ga₂O₃ single crystal growth apparatus including at least a crucible having a cylindrical shape and a heating device disposed so as to surround an outer periphery of the crucible (preparation step S110) is performed. In the preparation step S110, it is preferable that the seed crystal 81, a Ga₂O₃ bulk body that is in the form of a lump, a plate-shaped member composed of pBN, and a B₂O₃ in a solid state are prepared in addition to the Ga₂O₃ single crystal growth apparatus 100 for manufacturing the Ga₂O₃ single crystal. The seed crystal 81 is composed of a Ga₂O₃ single crystal. The Ga₂O₃ bulk body may be composed of a polycrystalline Ga₂O₃. The seed crystal 81, the Ga₂O₃ bulk body that is in the form of a lump, the plate-shaped member 3, and the B₂O₃ in the solid state may be prepared by a conventionally known method, or may be prepared by obtaining commercially available products. As the crucible 5 constituting the Ga₂O₃ single crystal growth apparatus 100, the first crucible 5A or the second crucible 5B having the above-described structure is selected. The Ga₂O₃ single crystal growth apparatus 100 is preferably installed in the chamber 2 so that an atmosphere for performing a Ga₂O₃ single-crystal growth step S140, which will be described later, is an inert gas atmosphere. Examples of the inert gas include nitrogen and argon. Subsequently, in the Ga₂O₃ single-crystal manufacturing step S100, steps of obtaining a Ga₂O₃ single crystal are executed by performing crystal growth using a Ga₂O₃ single crystal growth apparatus.

### (Second Step: Raw Material Charging Step S120)

The raw material charging step S120 is a step of placing the seed crystal in the bottom portion of the crucible, and placing the Ga₂O₃ bulk body, the plate-shaped member, and the B₂O₃ in that order above the seed crystal in the crucible. The purpose of the raw material charging step S120 is to enclose various raw materials for performing crystal growth using the Ga₂O₃ single crystal growth apparatus 100 in the crucible. In the raw material charging step S120, first, the seed crystal 81 composed of a Ga₂O₃ single crystal is charged into the hollow portion of the seed-crystal placing portion 51 of the crucible 5. Next, a plurality of Ga₂O₃ bulk bodies that are each in the form of a lump and composed of polycrystalline Ga₂O₃ are individually charged into the diameter increasing portion 52 and the straight body portion 53 of the crucible 5 and stacked. Then, the plate-shaped member 3 is disposed on the Ga₂O₃ bulk bodies, and the B₂O₃ in the solid state is disposed on the plate-shaped member 3. In the raw material charging step S120, when the plurality of Ga₂O₃ bulk bodies that are each in the form of a lump are individually charged into the crucible 5, it is preferable to add a predetermined amount of Sn or Si. Thus, a Ga₂O₃ single-crystal substrate including Sn or Si as a dopant is obtained from the Ga₂O₃ single crystal obtained in the Ga₂O₃ single crystal manufacturing step S100. In the addition of Sn or Si, the amount of addition is preferably adjusted such that the concentration of the dopant is not more than 2× 10¹⁹ cm⁻³ (for example, 1.0 × 10¹⁷ cm⁻³ to 2 × 10¹⁹ cm⁻³) in the Ga₂O₃ single-crystal substrate.

### (Third Step: Raw Material Melting Step S130)

The raw material melting step S130 is a step of, by heating the crucible by the heating device to melt the Ga₂O₃ bulk body and a portion of the seed crystal, obtaining a Ga₂O₃ melt and bringing the Ga₂O₃ melt into contact with a remaining portion of the seed crystal. The purpose of the raw material melting step S130 is to melt the Ga₂O₃ bulk body and a portion of the seed crystal 81 to bring the remaining portion of the seed crystal 81 into contact with the Ga₂O₃ melt 82 when crystal growth is performed using the Ga₂O₃ single crystal growth apparatus 100. Thus, in the next step, the Ga₂O₃ single-crystal growth step S140, the Ga₂O₃ single crystal can be crystal grown on the remaining portion of seed crystal 81. In the raw material melting step S130, in detail, the crucible 5 in which the seed crystal 81, the Ga₂O₃ bulk body, the plate-shaped member 3, and the solid B₂O₃ are disposed is supported by the crucible holding stage 6 installed in the chamber 2. Thereafter, the heating device 9 is supplied with current and the crucible 5 is heated. As a result, the B₂O₃ in the solid state is melted to become B₂O₃ 4 in a liquid state, and the Ga₂O₃ bulk body is melted to become the Ga₂O₃ melt 82. Then, a portion of the seed crystal 81 is also melted, and the remaining portion of the seed crystal 81 and the Ga₂O₃ melt 82 are brought into contact with each other at the interface.

### (Fourth Step: Ga₂O₃ Single-Crystal Growth Step S140)

The Ga₂O₃ single-crystal growth step S140 is a step of obtaining the Ga₂O₃ single crystal by growing a crystal from the Ga₂O₃ melt on the remaining portion of the seed crystal. In the Ga₂O₃ single-crystal growth step S140, for example, the crucible 5 is gradually pulled down (toward the seed-crystal placing portion 51) along the shaft thereof with respect to the heating device 9, whereby a temperature gradient can be formed such that the temperature on the seed crystal 81 side is low and the temperature on the Ga₂O₃ melt 82 side is high in the crucible 5. Thus, the Ga₂O₃ melt 82 in contact with the seed crystal 81 is solidified, and the Ga₂O₃ single crystal can be continuously crystal grown from the Ga₂O₃ melt 82 on the remaining portion of seed crystal 81. The speed at which the crucible 5 is pulled downward along its shaft is not particularly limited, but may be, for example, 0.2 to 3 mm/hour.

The Ga₂O₃ single-crystal growth step S140 may be performed using the Ga₂O₃ single crystal growth apparatus 100 including the first crucible 5A or the second crucible 5B having the above-described structure. This makes it possible to make the shape of the interface between the Ga₂O₃ melt and the Ga₂O₃ single crystal flat, particularly when the Ga₂O₃ single crystal grows in the diameter increasing portion 52, and thereby stabilize the growth rate of the Ga₂O₃ single crystal. Further, in the Ga₂O₃ single-crystal growth step S140, when the Ga₂O₃ single crystal is grown in the straight body portion 53, the growth rate of the Ga₂O₃ single crystal can be stabilized by adjusting the output of the heating device 9. As described above, the Ga₂O₃ single crystal manufacturing step S 100 can obtain a Ga₂O₃ single crystal having a uniform crystal defect concentration without any bias.

In the Ga₂O₃ single-crystal growth step S 140, the crucible 5 (first crucible 5A or second crucible 5B) is pulled downward along its shaft with respect to the heating device 9, whereby the interface between the Ga₂O₃ single crystal and the Ga₂O₃ melt 82 rises toward the B₂O₃ 4 in the liquid state, and the Ga₂O₃ melt 82 is solidified as the Ga₂O₃ single crystal. Thus, the crystal growth of the Ga₂O₃ single crystal is continued until the solidification of the Ga₂O₃ melt 82 remaining in the straight body portion 53 of the crucible 5 (first crucible 5A or second crucible 5B) is completed. In this way, the ingot of Ga₂O₃ single crystal can be obtained.

[Method of Manufacturing Digallium Trioxide Single-Crystal Substrate]

### <Ga₂O₃ Single-Crystal Substrate Manufacturing Step S200>

A method of manufacturing a Ga₂O₃ single-crystal substrate according to the embodiment includes a step of obtaining a Ga₂O₃ single-crystal substrate having a circular main surface by processing a Ga₂O₃ single crystal obtained by the method of manufacturing a Ga₂O₃ single crystal. As shown in FIG. 3, the method of manufacturing the Ga₂O₃ single-crystal substrate includes a Ga₂O₃ single crystal manufacturing step S 100 and the Ga₂O₃ single-crystal substrate manufacturing step S200. The purpose of the Ga₂O₃ single-crystal substrate manufacturing step S200 is to obtain a Ga₂O₃ single-crystal substrate by processing the Ga₂O₃ single crystal obtained by the Ga₂O₃ single crystal manufacturing step S100. The Ga₂O₃ single-crystal substrate manufacturing step S200 includes a cutting step, an outer periphery grinding step, and a polishing step, and these steps are performed in this order, thereby obtaining the Ga₂O₃ single-crystal substrate.

The cutting step is a step of slicing the ingot into wafers having a predetermined thickness in order to obtain a Ga₂O₃ single-crystal substrate from the ingot composed of Ga₂O₃ single crystal taken out from the crucible 5. The outer periphery grinding step is a step of grinding the outer periphery of the wafer to obtain a wafer having a main surface including a central portion and an outer peripheral portion surrounding the outer periphery of the central portion. The outer periphery grinding step is a step of chamfering. Thus, the main surface having the chamfered region as the outer peripheral portion can be obtained by the outer periphery grinding step. As the cutting step and the outer periphery grinding step, a conventionally known cutting method and outer periphery grinding method can be used. The polishing step is a step of mirror-finishing the central portion of the main surface. As the polishing step, a conventionally known polishing method can be used. By the polishing step, the center portion can be made to have a surface roughness Ra of 20 nm or less, for example, as specified in JIS B 0681-2:2018.

### [Effects]

By performing each of the above steps, the Ga₂O₃ single-crystal substrate according to the embodiment is manufactured. In the method of manufacturing the Ga₂O₃ single crystal, the Ga₂O₃ single crystal having uniform crystal defect concentration can be crystal grown particularly in the Ga₂O₃ single-crystal growth step S140. Thus, a Ga₂O₃ single-crystal substrate having a main surface with a predetermined hardness in-plane and uniform without variation can be obtained from the Ga₂O₃ single crystal. As described above, the present disclosure can obtain a Ga₂O₃ single-crystal substrate that is less likely to form the starting points of fracture such as cracks in the main surface and is less likely to be cracked, based on the characteristics relating to the hardness described above.

### EXAMPLES

The present disclosure will be described in more detail with reference to the following examples, but the present disclosure is not limited thereto. In this example, a Ga₂O₃ single-crystal substrate was manufactured according to the flowchart shown in FIG. 3 using a Ga₂O₃ single crystal production device as shown in FIG. 4, a crucible as shown in FIGS. 5 and 6, and a plate-shaped member as shown in FIG. 7. In the following description, sample 1 and sample 2 are examples, and sample a is a comparative example.

### [Manufacturing of Ga₂O₃ Single-Crystal Substrate]

### <Sample 1>

### (Preparation Step S110 in Ga₂O₃ Single Crystal Manufacturing Step S100)

First, the Ga₂O₃ single crystal growth apparatus 100, the seed crystal 81 made of a Ga₂O₃ single crystal, the Ga₂O₃ bulk body that is in the form of a lump and composed of a polycrystalline Ga₂O₃, the plate-shaped member 3 composed of pBN, and B₂O₃ in a solid state were prepared by a conventionally known method or by obtaining commercially available materials. The chamber 2 for accommodating the Ga₂O₃ single crystal growth apparatus 100 was also prepared. As the crucible 5 constituting the Ga₂O₃ single crystal growth apparatus 100, the first crucible 5A having three side surface portions as described above in the diameter increasing portion 52 was manufactured by a conventionally known method and used. Further, the inside of the chamber 2 was made to be a nitrogen gas atmosphere for the purpose of executing the Ga₂O₃ single-crystal growth step S140 described later under an inert gas atmosphere.

Here, the diameter increasing portion 52 of the first crucible 5A has three positions at each of which a ratio S/Z of the area S of a cross section of the diameter increasing portion 52 orthogonal to the axial direction of the first crucible 5A in the upward axial direction of the first crucible to the distance Z in the axial direction from the connection point between the diameter increasing portion 52 and the seed-crystal placing portion 51 is 157.1 mm. The diameter increasing portion 52 of the first crucible 5A has a shape specified by the distance Z, the area S, and the S/Z described above, which are specifically shown in Table 1 below. That is, as shown in Table 1 below, the diameter increasing portion 52 of the first crucible 5A has a shape having three side surface portions including the lower portion 52a in which the distance Z is from the 0 mm to 11.52 mm, the middle portion 52b in which the distance Z is from 11.52 mm to 28.88 mm, and the upper portion 52c in which the distance Z is from 28.88 mm to 54.07 mm. Further, the S/Z is respectively 157.1 mm at the boundary between the lower portion 52a and the middle portion 52b, the boundary between the middle portion 52b and the upper portion 52c, and the boundary between the upper portion 52c and the straight body portion 53. In Table 1 below, "R" represents a radius of a cross section (circle) orthogonal to the axial direction at the point of the distance Z of the diameter increasing portion 52 of the first crucible 5A. The inner diameter of the straight body portion 53 of the first crucible 5A is 104 mm.

### [Table 1]

**Table. 1**

| Z (mm) | R (mm) | S (mm²) | S/Z (mm) |
|---|---|---|---|
| 0 | 10.00 | 314 | - |
| 11.52 | 24.00 | 1810 | 157.1 |
| 28.88 | 38.00 | 4536 | 157.1 |
| 54.07 | 52.00 | 8495 | 157.1 |

### (Raw Material Charging Step S120 in Ga₂O₃ Single Crystal Manufacturing Step S100)

Next, by a conventionally known method, the seed crystal 81 was accommodated in the bottom portion of the first crucible 5A, and the Ga₂O₃ bulk body, the plate-shaped member 3, and the solid B₂O₃ were accommodated in that order above the seed crystal 81 in the first crucible 5A. In detail, the seed crystal 81 composed of a Ga₂O₃ single crystal was inserted into the hollow portion of the seed-crystal placing portion 51 of the first crucible 5A. A plurality of Ga₂O₃ bulk bodies that were each in the form of a lump were individually charged into the diameter increasing portion 52 and the straight body portion 53 of the first crucible 5A and stacked. Subsequently, the plate-shaped member 3 was disposed on the Ga₂O₃ bulk body, and B₂O₃ in a solid state was disposed on the plate-shaped member 3. Further, when the plurality of Ga₂O₃ bulk bodies that were each in the form of a lump were individually charged into the first crucible 5A, a predetermined amount of Sn was added. The amount of Sn added was set such that the atomic concentration of Sn in the Ga₂O₃ single-crystal substrate was 3 × 10¹⁸ cm⁻³.

### (Raw Material Melting Step S130 in Ga₂O₃ Single Crystal Manufacturing Step S100)

Next, the seed crystal 81, the Ga₂O₃ bulk body, the plate-shaped member 3, and the first crucible 5A accommodating the B₂O₃ in the solid state therein were accommodated in the chamber 2, and the first crucible 5A was supported by the crucible holding stage 6 installed in the chamber 2. Thereafter, the first crucible 5A was heated by supplying an electric current to the heating device 9, whereby the B₂O₃ in the solid state was melted to form B₂O₃ 4 in a liquid state, and the Ga₂O₃ bulk body was melted to form the Ga₂O₃ melt 82. Then, a portion of the seed crystal 81 was also melted, and the remaining portion of the seed crystal 81 and the Ga₂O₃ melt 82 were brought into contact with each other at the interface.

### (Ga₂O₃ Single-Crystal Growth Step S140 in Ga₂O₃ Single Crystal Manufacturing Step S100)

Next, the first crucible 5A was gradually pulled downward (toward the seed-crystal placing portion 51) along the shaft thereof with respect to the heating device 9, thereby obtaining a temperature gradient in which the temperature on the seed crystal 81 side was low and the temperature on the Ga₂O₃ melt 82 side was high in the first crucible 5A. As a result, the Ga₂O₃ melt 82 in contact with the seed crystal 81 was solidified, and a Ga₂O₃ single crystal was continuously crystal grown from the Ga₂O₃ melt 82 on the remaining portion of the seed crystal 81. Further, this operation was continued until the solidification of the Ga₂O₃ melt 82 remaining in the straight body portion 53 of the first crucible 5A was completed. The speed at which the first crucible 5A was pulled downward along its shaft was 2 mm/hour. Thus, ingot of Ga₂O₃ single crystal was obtained.

### (Ga₂O₃ Single-Crystal Substrate Manufacturing Step S200)

Finally, the Ga₂O₃ single-crystal ingot obtained in the Ga₂O₃ single-crystal growth step S140 was processed in each of the cutting step, the outer periphery grinding step, and the polishing step, thereby obtaining a Ga₂O₃ single-crystal substrate. First, in the cutting step, the ingot was sliced into wafers having a thickness of 700 µm by a conventionally known method. In the outer periphery grinding step, the outer peripheral of the wafer was ground so as to be chamfered by using a conventionally known method, thereby obtaining a wafer having a main surface including a central portion and an outer peripheral portion surrounding the outer peripheral of the central portion. Further, in the polishing step, the central portion was polished by a conventionally known polishing method, and surface roughness Ra defined by JIS B 0681-2:2018, for example, was set as a 20 nm in the central portion. In this way, a Ga₂O₃ single-crystal substrate of sample 1 was produced.

The diameter of the Ga₂O₃ single-crystal substrate of sample 1 was 100 mm. The thickness of the Ga₂O₃ single-crystal substrate of sample 1 was 650 µm. The dislocation density of the central portion of the Ga₂O₃ single-crystal substrate of sample 1 measured by the above-described method was 100 cm⁻².

### <Sample 2>

A Ga₂O₃ single-crystal substrate of sample 2 was manufactured in the same manner as sample 1, except that the second crucible 5B having four side surface portions as described above in the diameter increasing portion 52 was manufactured by a conventionally known method and used as the crucible 5 constituting the Ga₂O₃ single crystal growth apparatus 100. The diameter of the Ga₂O₃ single-crystal substrate of sample 2 was 100 mm. The thickness of the Ga₂O₃ single-crystal substrate of sample 1 was 650 µm. The dislocation density of the central portion of the Ga₂O₃ single-crystal substrate of sample 2 measured by the above-described method was 50 cm⁻².

Here, the diameter increasing portion 52 of the second crucible 5B has 4 positions at each of which a ratio S/Z of the area S of a cross section of the diameter increasing portion 52 orthogonal to the axial direction in the upward axial direction of the second crucible 5B to the distance Z in the axial direction of the second crucible 5B from the connection point between the diameter increasing portion 52 and the seed-crystal placing portion 51 to is 157.1 mm. The diameter increasing portion 52 of the second crucible 5B has a shape specified by the distance Z, the area S, and the S/Z described above, which are specifically shown in Table 2 below. That is, as shown in Table 2 below, the diameter increasing portion 52 of the second crucible 5B has a shape having four side surface portions including the lowermost portion 52d in which the distance Z is from the 0 mm to 8.00 mm, the first middle portion 52e in which the distance Z is from 8.00 mm to 18.00 mm, the second middle portion 52f in which the distance Z is from 18.00 mm to 32.00 mm, and the uppermost portion 52g in which the distance Z is from 32.00 mm to 50.00 mm. Further, the S/Z is 157.1 mm at the boundary between the lowermost portion 52d and the first middle portion 52e, the boundary between the first middle portion 52e and the second middle portion 52f, the boundary between the second middle portion 52f and the uppermost portion 52g, and the boundary between the uppermost portion 52g and the straight body portion 53. In Table 2 below, "R" represents a radius of a cross section (circle) orthogonal to the axial direction at the point of the distance Z of the diameter increasing portion 52 of the second crucible 5B. The inner diameter of the straight body portion 53 of the second crucible 5B is the 100 mm.

### [Table 2]

**Table. 2**

| Z (mm) | R (mm) | S (mm²) | S/Z (mm) |
|---|---|---|---|
| 0 | 10.00 | 314 | - |
| 8.00 | 20.00 | 1257 | 157.1 |
| 18.00 | 30.00 | 2827 | 157.1 |
| 32.00 | 40.00 | 5027 | 157.1 |
| 50.00 | 50.00 | 7854 | 157.1 |

### <Sample a>

A Ga₂O₃ single-crystal substrate of sample a was manufactured in the same manner as in sample 1 except that a conventionally known crucible having a truncated conical shape that expands upward in the axial direction was manufactured and used as the crucible constituting the Ga₂O₃ single crystal growth apparatus. The diameter of the Ga₂O₃ single-crystal substrate of sample a was 100 mm. The thickness of the Ga₂O₃ single-crystal substrate of sample a was 650 µm. The dislocation density of the central portion of the Ga₂O₃ single-crystal substrate of the sample a measured by the above-described method was 500 cm⁻².

### [Measurement of Nanoindentation Hardness]

The above-described measurement method was performed on the Ga₂O₃ single-crystal substrates of sample 1 to sample 2 and sample a, and thus the first nanoindentation hardnesses and the second nanoindentation hardnesses at predetermined nine positions on the main surface were obtained respectively. The measurement apparatus and measurement conditions used for performing the above-described measurement method are as follows.

Used apparatus: Nanoindenter (trade name: "Bruker Hysitron TI980 Triboindenter", manufactured by Bruker Japan Co., Ltd.)
Indenter used: Berkovich indenter
Maximum load: 1mN or 10mN
Measurement atmosphere: atmospheric air
Measurement temperature: room temperature (25°C.)
Crossing angle between at least one side of the indenter ridge and the direction of the [100] direction of the Ga₂O₃ single crystal projected onto the main surface: 0 to 10°.

The same positions were measured three times on the same substrate, and the average value (units: GPa) of the three measured values was taken as the first nanoindentation hardness and the second nanoindentation hardness at each of the predetermined nine positions on the main surface. Further, the difference (Δ (max-min)) between the maximum value and the minimum value of the first nanoindentation hardness and the second nanoindentation hardness at each of the predetermined nine positions on the main surface was also obtained. The predetermined nine positions refer to the following positions on the main surface. That is, when a length from the center of the main surface to a boundary between the central portion and the outer peripheral portion is r, two axes passing through the center and orthogonal to each other on the main surface are an X-axis and a Y-axis, and the Y-axis is a b-axis of the Ga₂O₃ single crystal, coordinates (X, Y) of the X-axis and the Y-axis at the nine positions are (0, 0), (r-5, 0), (0, r-5), (-(r-5), 0), (0, -(r-5)), (r-1, 0), (0, r-1), (-(r-1), 0), and (0, -(r-1)). The units of r and X and Y in the coordinates (X, Y) are mm. In the Ga₂O₃ single-crystal substrate of each of sample 1, sample 2, and sample a, r is 48 mm. The results are shown in Tables 3 and 4. Table 3 shows the first nanoindentation hardnesses at 9 predetermined positions on the main surface, and Table 4 shows the second nanoindentation hardnesses at 9 predetermined positions on the main surface. Tables 3 and 4 also show the standard deviation (units: GPa) of three measured values obtained by measuring the same positions three times on the same substrate.

### [Table 3]

**Table. 3**

| | Sample a | | Sample 1 | | Sample 2 | |
|---|---|---|---|---|---|---|
| (X,Y) | Average Value (GPa) | Standard Deviation (GPa) | Average Value (GPa) | Standard Deviation (GPa) | Average Value (GPa) | Standard Deviation (GPa) |
| (0,0) | 13.2 | 0.1 | 13.4 | 0.1 | 13.6 | 0.1 |
| (r-5,0) | 13.5 | 0.1 | 13.6 | 0.1 | 13.9 | 0.1 |
| (0,r-5) | 12.8 | 0.1 | 13.0 | 0.1 | 13.5 | 0.1 |
| (-(r-5),0) | 13.1 | 0.1 | 13.3 | 0.1 | 13.5 | 0.1 |
| (0,-(r-5)) | 13.0 | 0.1 | 13.2 | 0.1 | 13.5 | 0.1 |
| (r-1,0) | 13.5 | 0.1 | 13.7 | 0.1 | 13.9 | 0.1 |
| (0,r-1) | 13.0 | 0.1 | 13.2 | 0.1 | 13.5 | 0.1 |
| (-(r-1),0) | 13.1 | 0.1 | 13.3 | 0.1 | 13.5 | 0.1 |
| (0,-(r-1)) | 13.0 | 0.2 | 13.2 | 0.1 | 13.5 | 0.1 |
| Δ(max-min) | 0.7 | - | 0.5 | - | 0.4 | - |

### [Table 4]

**Table. 4**

| | Sample a | | Sam | ple 1 | Sample 2 | |
|---|---|---|---|---|---|---|
| (X,Y) | Average Value (GPa) | Standard Deviation (GPa) | Average Value (GPa) | Standard Deviation (GPa) | Average Value (GPa) | Standard Deviation (GPa) |
| (0,0) | 15.5 | 0.3 | 15.7 | 0.2 | 15.9 | 0.2 |
| (r-5,0) | 15.3 | 0.2 | 15.2 | 0.2 | 15.5 | 0.2 |
| (0,r-5) | 15.2 | 0.3 | 15.4 | 0.2 | 15.6 | 0.2 |
| (-(r-5),0) | 15.0 | 0.4 | 15.2 | 0.2 | 15.5 | 0.2 |
| (0,-(r-5)) | 15.5 | 0.5 | 15.7 | 0.2 | 15.8 | 0.2 |
| (r-1,0) | 15.2 | 0.2 | 15.4 | 0.2 | 15.6 | 0.2 |
| (0,r-1) | 15.1 | 0.3 | 15.3 | 0.2 | 15.5 | 0.2 |
| (-(r-1),0) | 14.8 | 0.4 | 15.2 | 0.2 | 15.5 | 0.2 |
| (0,-(r-1)) | 15.5 | 0.5 | 15.7 | 0.2 | 15.9 | 0.2 |
| Δ(max-min) | 0.7 | - | 0.5 | - | 0.4 | - |

### [Discussion]

According to Tables 3 and 4, in the Ga₂O₃ single-crystal substrates of sample 1 and sample 2, the first nanoindentation hardnesses measured at nine positions on the main surface were each 13 GPa to 20 GPa. Thus, it was suggested that the Ga₂O₃ single-crystal substrates of sample 1 and sample 2 were less likely to have starting points of fracture such as cracks formed in the main surface, and thus were less likely to be cracked. Further, in the Ga₂O₃ single-crystal substrate of sample 1 to sample 2, the second nanoindentation hardnesses measured at nine positions on the main surface were each 15 GPa to 20 GPa, suggesting that the Ga₂O₃ single-crystal substrates of sample 1 and sample 2 were more resistant to cracking. On the other hand, in the Ga₂O₃ single-crystal substrate of sample a, the first nanoindentation hardnesses measured at nine positions on the main surface was less than 13 GPa at any of the positions.

Although the embodiments and examples of the present disclosure have been described above, it is originally intended to appropriately combine the configurations of the above-described embodiments and examples.

The embodiments and examples disclosed herein are illustrative in all respects and should not be construed as limiting. The scope of the present invention is defined by the appended claims rather than by the foregoing embodiments and examples, and is intended to include any modifications within the scope and meaning equivalent to the scope of the claims.

### REFERENCE SIGNS LIST

1 digallium trioxide single-crystal substrate (Ga₂O₃ single-crystal substrate), 10 main surface, 11 central portion, 12 outer peripheral portion, 13 boundary, 2 chamber, 3 plate-shaped member, 3a through-hole, 4 liquid boron oxide (B₂O₃), 5 crucible, 5A first crucible, 5B second crucible, 51 seed-crystal placing portion, 52 diameter increasing portion, 52a lower portion, 52b middle portion, 52c upper portion, 52d lowermost portion, 52e first middle portion, 52f second middle portion, 52g uppermost portion, 53 straight body portion, 6 crucible holding stage, 7 lower shaft, 81 seed crystal, 82 digallium trioxide melt (Ga₂O₃ melt), 9 heating device, 100 single crystal growth apparatus, O center, r length from center of main surface to boundary between central portion and outer peripheral portion, S area, Z distance, S100 Ga₂O₃ single crystal manufacturing step, S110 preparation step, S120 raw material charging step, S130 raw material melting step, S140 Ga₂O₃ single-crystal growth step, S200 Ga₂O₃ single-crystal substrate manufacturing step.

## Claims

1. A digallium trioxide single-crystal substrate comprising a circular main surface,
wherein the digallium trioxide single-crystal substrate has a diameter of 100 mm or more,
the main surface is a (001) plane of a digallium trioxide single crystal constituting the digallium trioxide single-crystal substrate,
the main surface has a central portion including a center of the main surface and an outer peripheral portion surrounding an outer periphery of the central portion,
the outer peripheral portion is a chamfered region,
first nanoindentation hardnesses measured at nine positions on the main surface in accordance with a nanoindentation method using a Berkovich indenter are each 13 GPa to 20 GPa under a first condition in which a maximum load is set to 10 mN and a load is applied such that a crossing angle between one side of an indentation and a direction in which a [100] direction of the digallium trioxide single crystal is projected on the main surface is 0° to 10°, and
when a length from the center of the main surface to a boundary between the central portion and the outer peripheral portion is r, two axes passing through the center and orthogonal to each other on the main surface are an X-axis and a Y-axis, and the Y-axis is a b-axis of the digallium trioxide single crystal, coordinates (X, Y) of the X-axis and the Y-axis at the nine positions are (0, 0), (r-5, 0), (0, r-5), (-(r-5), 0), (0, -(r-5)), (r-1, 0), (0, r-1), (-(r-1), 0), and (0, -(r-1)), and units of r and X and Y in the coordinates (X, Y) are mm.

2. The digallium trioxide single-crystal substrate according to claim 1, wherein second nanoindentation hardnesses measured at the nine positions in accordance with the nanoindentation method are each 15 GPa to 20 GPa under a second condition in which the maximum load is set to 1 mN and the load is applied such that the crossing angle between the one side of the indentation and the direction in which the [100] direction of the digallium trioxide single crystal is projected on the main surface is 0° to 10°.

3. The digallium trioxide single-crystal substrate according to claim 1 or 2, wherein a dislocation density of the central portion is 100 cm⁻² or less.

4. The digallium trioxide single-crystal substrate according to any one of claims 1 to 3,
wherein the digallium trioxide single-crystal substrate includes a dopant,
the dopant is tin or silicon, and
an atomic concentration of the dopant is 2 × 10¹⁹ cm⁻³ or less.

5. A method of manufacturing a digallium trioxide single crystal, the method comprising:
preparing a single crystal growth apparatus including at least a crucible having a cylindrical shape and a heating device disposed so as to surround an outer periphery of the crucible;
placing a seed crystal in a bottom portion of the crucible, and placing a digallium trioxide bulk body that is in a form of a lump, a plate-shaped member composed of pyrolytic boron nitride, and boron oxide in a solid state in that order above the seed crystal in the crucible;
by heating the crucible by the heating device to melt the digallium trioxide bulk body and a portion of the seed crystal, obtaining a digallium trioxide melt and bringing the digallium trioxide melt into contact with a remaining portion of the seed crystal; and
obtaining the digallium trioxide single crystal by growing a crystal from the digallium trioxide melt on the remaining portion of the seed crystal,
wherein the bringing the digallium trioxide melt into contact with the remaining portion of the seed crystal includes disposing the plate-shaped member on the digallium trioxide melt and turning the boron oxide into liquid,
an atmosphere in which the obtaining the digallium trioxide single crystal is performed is an inert gas atmosphere,
the crucible includes a seed-crystal placing portion having a cylindrical shape, a diameter increasing portion connected to the seed-crystal placing portion, and a straight body portion connected to the diameter increasing portion,
the seed-crystal placing portion has a hollow portion that opens on a side connected to the diameter increasing portion and that is provided with a bottom wall on a side opposite to the diameter increasing portion,
the diameter increasing portion has a shape in which an area S of a cross section of the diameter increasing portion orthogonal to an axial direction of the crucible increases upward in the axial direction, and is connected to the seed-crystal placing portion on a small-diameter side of the diameter increasing portion,
the diameter increasing portion has three or four positions at each of which a ratio S/Z of the area S to a distance Z in the axial direction of the crucible from a connection point between the diameter increasing portion and the seed-crystal placing portion is 157.1 mm,
the straight body portion has a hollow cylindrical shape and is connected to a large-diameter side of the diameter increasing portion,
the plate-shaped member has a plurality of through-holes each extending through the plate-shaped member in a direction parallel to the axial direction in a state in which the plate-shaped member is disposed on the digallium trioxide melt,
an area proportion of the plurality of through-holes occupying a cross section of the plate-shaped member orthogonal to the axial direction is 0.12 to 0.28, and
a unit of the distance Z is mm, a unit of the area S is mm², and a unit of S/Z is mm.

6. A method of manufacturing a digallium trioxide single-crystal substrate, the method comprising obtaining a digallium trioxide single-crystal substrate having a circular main surface by processing the digallium trioxide single crystal obtained by the method of manufacturing a digallium trioxide single crystal according to claim 5.

7. The digallium trioxide single-crystal substrate according to claim 2,
wherein a dislocation density of the central portion is 100 cm⁻² or less,
the digallium trioxide single-crystal substrate includes a dopant,
the dopant is tin, and
an atomic concentration of the dopant is 2 × 10¹⁹ cm⁻³ or less.
